Europäisches Patentamt

European Patent Office

Office européen des brevets

(19)

(11) Numéro de publication: **0 219 408**
B1

(12) **FASCICULE DE BREVET EUROPEEN**

(45) Date de publication du fascicule du brevet:
09.08.89

(51) Int. Cl.⁴: **H01L 21/00**, B23K 20/02,
H01L 21/603

(21) Numéro de dépôt: **86402137.3**

(22) Date de dépôt: **01.10.86**

(54) **Procédé et dispositif de soudage d'éléments sur les plots correspondants d'une plaquette telle que notamment une plaquette de circuits intégrés de haute densité.**

(30) Priorité: **02.10.85 FR 8514587**

(43) Date de publication de la demande:
**22.04.87 Bulletin 87/17**

(45) Mention de la délivrance du brevet:
**09.08.89 Bulletin 89/32**

(84) Etats contractants désignés:
**CH DE FR GB LI SE**

(56) Documents cités:
**FR-A- 2 067 218**

**TECHNICAL DIGEST-WESTERN ELECTRIC,
no. 12, octobre 1968, pages 1,2, New York, US; H.A.
BAILY et al.: "Sequential bonding"**

(73) Titulaire: **BULL S.A., 121 avenue de Malakoff P.B. 193.16,
F-75764 Paris Cédex 16(FR)**

(72) Inventeur: **Le Meau, Michel, 16 allée du Bois, F-44240 La
Chapelle sur Erdre(FR)**
Inventeur: **Boiteau, Jean-Pierre, Le Gibet,
F-49140 Villeveque(FR)**
Inventeur: **Vernon, Jean-Yves, 56 avenue de la Boissière,
F-49240 Avrille(FR)**

(74) Mandataire: **Denis, Hervé et al, BULL S.A. Industrial
Property Department 25 avenue de la Grande-Armée,
F-75016 Paris(FR)**

ACTORUM AG

## Description

L'invention se rapporte à un procédé et un dispositif de soudage d'éléments sur les plots correspondants d'une plaquette. En général, l'invention s'applique aux plaquettes du domaine électrique ou électronique, auxquelles le soudage simultané des éléments sur leurs plots exerce des forces excessives ou dommageables, ou n'assure plus de bonnes soudures sur l'ensemble des plots. L'invention s'applique ainsi notamment au soudage d'éléments conducteurs sur les plots correspondants d'une plaquette de circuits imprimés et, plus particulièrement, d'une plaquette de circuits intégrés de haute densité, appelée couramment puce ou chip VLSI (Very Large Scale Integration). Etant donné que le soudage classique sur puces VLSI soulève tous les problèmes résolus par l'invention, il sera pris comme exemple d'illustration dans la suite du texte.

Les puces sont ordinairement des plaquettes rectangulaires de silicium, approximativement carrées, dont une face inclut des circuits intégrés et les plots constituant les bornes d'entrée-sortie. Ces plaquettes sont très minces, de l'ordre de 200 à 700 micromètres, et leur surface dépend de la nature des circuits et de leur intégration. Les plus grandes ont actuellement 10 à 15 mm de côté et comportent plus de 350 plots périphériques généralement disposés en ligne ou en quinconce de part et d'autre d'une ligne géométrique approximativement carrée.

Les puces sont originellement formées sur une tranche de silicium (wafer). Elles y sont ensuite prélevées pour entrer dans les boîtiers ou être portées par un ruban en vue d'une utilisation sans boîtier (technologie couramment appelée "micropack"). Le ruban sert au transport et au montage automatique des puces sur des plaquettes de circuits imprimés et est ainsi appelé couramment ruban TAB (Tape Automated Bonding). Les puces sont montées dans les boîtiers ou sur le ruban, en soudant leurs plots aux extrémités de conducteurs correspondants faisant partie du boîtier ou du ruban.

Le soudage est fait de manière classique par un dispositif comprenant une table destinée à recevoir au moins une puce dans une position prédéterminée, un bloc de positionnement des conducteurs par rapport aux plots respectifs de la puce, un outil de soudage pourvu d'une sole de chauffage couvrant l'ensemble des plots à souder, un mécanisme pour déplacer relativement la table et l'outil de soudage, et un dispositif d'application de force pour le soudage des conducteurs aux plots correspondants de la puce.

Le procédé classique de soudage consiste à placer une puce sur la table, à positionner les conducteurs par rapport aux plots respectifs de la puce, à mettre en position de soudage la sole de l'outil de soudage, les conducteurs et les plots, puis à exercer simultanément une force prédéterminée pour le soudage collectif de tous les conducteurs aux plots de la puce. En général, la table est fixe et l'outil est posé sur les conducteurs et applique la force de soudage. Le type de soudage est ordinairement la thermocompression ou le brasage à base d'étain.

Le procédé et les dispositifs de soudage classiques appliqués aux puces de grande surface ou à nombreux plots présentent deux inconvénients majeurs.

Le premier inconvénient naît du fait que les plots ont une très faible surface, de l'ordre de 60 à 250 micromètres de côté, et ne peuvent ainsi recevoir que très peu d'étain pour la soudure. Il faut donc exercer sur chaque plot une pression de soudage relativement élevée, dont la valeur dépend de la surface du plot et vaut en moyenne environ 0,8 Newton. La thermocompression nécessite naturellement des pressions supérieures, de l'ordre du double. Par conséquent, le procédé classique de soudage simultané de l'ensemble des plots d'une puce de par exemple 200 plots aboutit à l'application d'une force totale très élevée, de l'ordre de 160 Newtons, soit 15kg. Les puces étant des plaquettes minces très fragiles, l'expérience montre que l'application de telles forces les endommage dans une grande proportion.

Cet inconvénient est aggravé par le fait que la puce ne repose pas en tout point sur la table et, d'autre part, que les surfaces supérieures des plots ne sont pas toutes coplanaires et n'épousent pas exactement la sole de l'outil de soudage. Il s'ensuit que l'outil de soudage exerce des contraintes plus ou moins fortes en différents points de la puce.

Le second inconvénient est dû à la disposition relative des plots avec la sole de l'outil de soudage. Celle-ci est initialement plane, mais elle se charge d'une manière non uniforme d'éléments issus de soudages successifs et s'oxyde très vite. La sole est donc nettoyée et rodée régulièrement. Cependant, le rodage use plus vite les bords de la sole et a pour effet de l'incurver. Les plots font ainsi plus ou moins contact avec la sole selon leur position par rapport à elle et reçoivent par conséquent des forces de soudage très diverses. Certaines, trop fortes, écrasent les conducteurs ou endommagent les plots ou leurs connexions aux circuits de la puce, et d'autres, trop faibles, produisent des soudures fragiles et peu fiables, voire défectueuses. Il en résulte, d'une part, que la bonne qualité de toutes les soudures n'est plus assurée et, d'autre part, que l'application inégale des forces de soudage crée dans la puce des contraintes qui s'ajoutent à celles précédemment citées.

Par ailleurs, les outils de soudage classiques ont une sole formée de quatre barrettes, assemblées à leurs extrêmités pour constituer un rectangle correspondant à la ligne des plots et portées par des piliers connectés mécaniquement et électriquement aux électrodes massives d'amenée du courant de chauffage. Les quatre barrettes de la sole sont faites en un matériau choisi comme compromis pour être à la fois bonne source de chaleur et offrir une bonne surface de pose. Le titane-aluminium réalise ce compromis, mais il a pour caractéristique de mal s'usiner. En outre, les barrettes des outils de soudage deviennent de plus en plus longues pour se conformer aux grandes puces et sont soumises à des pressions de plus en plus élevées pour exercer sur l'ensemble des plots les forces de soudage requises. Il s'ensuit que ces barrettes s'incurvent légèrement et qu'elles n'appliquent plus uniformément les pressions de soudage requises. Les effets qui en résultent s'ajoutent à ceux mentionnés au paragraphe précédent et rendent le soudage d'autant plus difficile.

En résumé, la technique antérieure pose le problème de souder des éléments sur les plots d'une plaquette sans endommager celle-ci sous l'effet de la force de soudage totale. Elle pose d'autre part le problème d'assurer une égale qualité de toutes les soudures sur l'ensemble des plots.

Une solution à ces deux problèmes est exposée dans l'article de Baily et al dans la revue "Technical Digest" de Western Electric, n° 12, octobre 1968, pages 1 et 2, intitulé "Sequential Bonding", ainsi que dans le brevet français n° 2 067 218. Le principe de la solution consiste à appliquer successivement une force de soudage prédéterminée sur chacun des éléments et des plots correspondants de la plaquette.

Les dispositifs de soudage décrits dans les deux documents ont une table fixe et un outil de soudage appliquant successivement la force de soudage sur les plots de la plaquette grâce à un mécanisme tournant autour de l'axe central de la plaquette selon un angle prédéterminé. Dans l'article cité, la table est fixe et l'outil de soudage présente un axe faisant un angle prédéterminé avec l'axe central de la table. L'outil est entraîné en rotation par une chaîne autour de l'axe central de la table pour le soudage successif de chaque élément sur le plot correspondant de la plaquette. Quant au brevet cité, l'outil de soudage exerce une force de soudage déterminée au moyen d'un corps massif et appliquée de façon tournante par l'arbre d'un moteur et par l'intermédiaire d'une tige faisant un angle prédéterminé avec l'axe central de la plaquette.

Le brevet cité fait aussi référence à un dispositif de soudage comprenant un outil de soudage fixe et une table montée oscillante pour exercer successivement la force de soudage sur chaque élément et le plot correspondant de la plaquette. Bien que le principe de soudage soit le même, la réalisation de ce dispositif de soudage demande la résolution de problèmes autres que ceux posés par l'application d'une force tournante par l'intermédiaire de l'outil de soudage. Le brevet cité expose clairement les difficultés majeures qu'il faut surmonter pour la bonne réalisation d'un dispositif de soudage à table oscillante. Il met aussi bien en relief le fait que ces difficultés ne peuvent être surmontées par de simples perfectionnements et que la solution la meilleure était de rendre l'outil tournant. Néanmoins, on constatera que les dispositifs de soudage à outil oscillant qui sont dans les documents cités sont aussi relativement complexes.

L'invention vise la réalisation d'un dispositif de soudage qui présente une solution simple et efficace aux problèmes soulevés par la mise en mouvement de la table par rapport à un outil de soudage fixe.

Selon l'invention, le procédé de soudage d'éléments sur les plots correspondants d'une plaquette au moyen d'un outil de soudage dont la sole couvre l'ensemble des plots, et en faisant osciller la plaquette par rapport à l'outil de soudage, est caractérisé en ce qu'on fait osciller la plaquette autour d'un point de sa région centrale par application sélective d'une force de soudage sur un certain nombre de points fixes prédéterminés, situés à l'intérieur de la ligne des plots de la plaquette, pour le soudage successif de groupes de plots.

En corollaire, un dispositif de soudage mettant en oeuvre le procédé conforme à l'invention, destiné au soudage d'éléments sur les plots correspondants d'une plaquette et comprenant : un outil de soudage dont la sole couvre l'ensemble des plots ; une table destinée à supporter la plaquette et montée oscillante par rapport à l'outil de soudage tout en étant bloquée en rotation dans son plan ; et un dispositif d'application de force de soudage faisant osciller la table pour le soudage successif des éléments sur les plots, est caractérisé en ce que la table est montée oscillante autour d'un point de la région du centre de la plaquette et le dispositif d'application de force de soudage comprend des tiges actionnées par des organes de commande respectifs et dont les axes sont parallèles à l'axe central de la table et coupent le plan de la ligne des plots en des points fixes prédéterminés intérieurs à cette ligne.

Les caractéristiques et avantages de l'invention ressortiront de la description qui suit, faite à titre d'exemple en référence aux dessins annexés.

Dans les dessins :

- la figure 1 est une vue de face avec arrachements partiels d'un dispositif de soudage conforme à l'invention ;
- la figure 2 est une vue de dessus avec arrachements partiels du dispositif de soudage représenté sur la figure 1, en l'absence de l'outil de soudage ;
- les figures 3A-3H illustrent respectivement des positions successives de soudage de conducteurs sur les plots d'une plaquette représentée schématiquement, au moyen du dispositif de soudage représenté sur les figures 1 et 2 ; et
- la figure 4 illustre une variante de réalisation pour le dispositif de soudage représenté sur les figures 1 et 2.

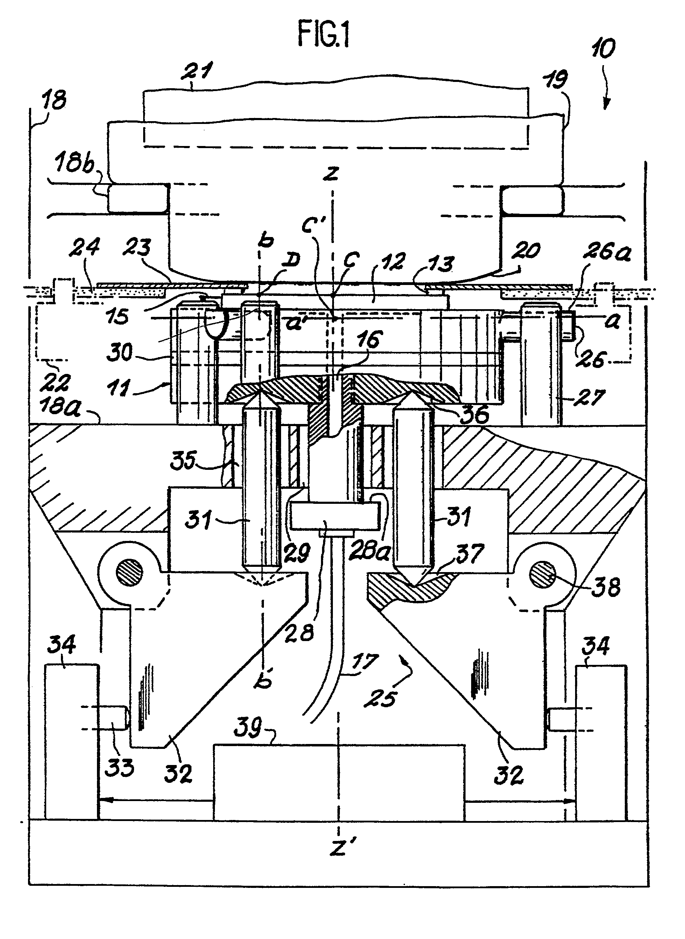

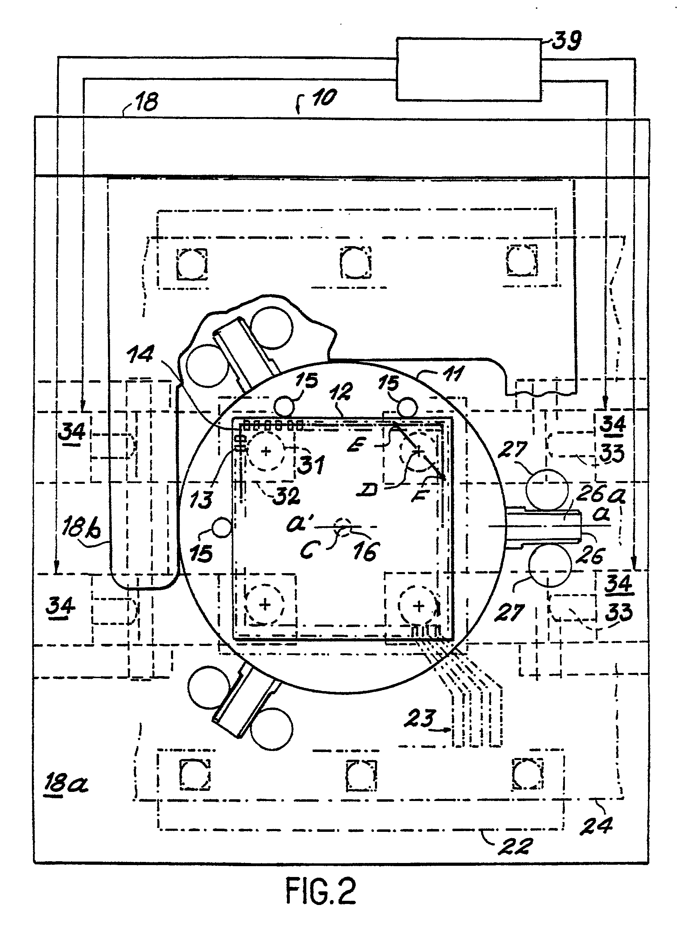

Les figures 1 et 2 représentent un dispositif de soudage 10 conforme à l'invention. De manière classique, le dispositif de soudage 10 comprend une table 11 destinée à recevoir dans une position prédéterminée une plaquette 12. La plaquette illustrée est une puce de circuits intégrés de haute densité pourvue de plots périphériques 13 disposés régulièrement suivant une ligne 14 parallèle à chaque côté de la puce et représentée par un trait mixte sur la figure 2. Une puce classique a une section rectangulaire généralement proche d'un carré. Par pure convention, toutes les figures annexes décrivent des puces carrées. On définit le centre C d'une puce par le point de croisement de ses diagonales dans le plan des surfaces supérieures des plots 13. L'axe ZZ' passant par le centre C normalement au plan de la plaquette 12 est pris ordinairement comme axe de référence vertical de positionnement dans un dispositif de soudage. La puce 12 est positionnée sur la table 11 à l'aide de trois pions ou galets 15 conformément au brevet français 2 397 125 de la demanderesse. La table 11 est traversée, suivant l'axe ZZ', par un canal 16 relié par un conduit 17 à une source de vide non illustrée, afin de maintenir la puce en position.

De manière classique également, le bâti 18 du dispositif de soudage 10 porte un outil de soudage 19 muni d'une sole de chauffage 20. La sole est plane à l'origine et est adaptée selon le type de plaquette 12 pour couvrir l'ensemble des plots 13 à souder. Dans la figure 1, la sole est une couronne plane carrée dont la ligne médiane correspond à la ligne 14 des plots 13 de la puce 12 et dont la largeur est supérieure à la longueur des plots dans le sens normal à la ligne 14. Le bâti 18 comporte un mécanisme 21 pour déplacer relativement la table et l'outil de soudage jusqu'à placer les plots en position de soudage. Dans l'exemple illustré, le mécanisme 21 correspond au cas ordinaire où il agit pour monter et descendre l'outil. En outre, le bâti 18 supporte un bloc de positionnement 22 de conducteurs 23 par rapport aux plots 13 de la plaquette. On a supposé dans l'exemple illustré que les conducteurs 23 sont portés par un ruban TAB 24 déplacé et positionné par rapport à l'axe ZZ' par le bloc de positionnement 22 de la manière décrite par exemple dans le brevet français 2 225 977 de la demanderesse. Enfin, le dispositif de soudage 10 inclut un dispositif d'application de force 25 pour le soudage des conducteurs 23 aux plots 13 correspondants de la puce.

Dans le dispositif de soudage 10 représenté sur les figures 1 et 2, la force de soudage est produite par le dispositif d'application de force 25 agissant sur la table 11 montée oscillante. Plus précisément, la table 11 est montée oscillante autour de l'axe ZZ' en un point C' de la région du centre C de la puce. Pour des raisons de commodité, la table 11 illustrée est cylindrique, d'axe ZZ', et oscille autour du point C' défini par l'intersection des axes (aa') coplanaires de trois rayons 26 disposés régulièrement sur sa périphérie. Chaque rayon 26 est placé à contact entre deux colonnes verticales 27 fixées à la platine (18a) du bâti 18 de façon à permettre le déplacement vertical et l'oscillation de la table autour du point C' tout en empêchant la table de tourner dans son plan autour de son axe ZZ'.

D'autre part, la table 11 est pourvue d'une vis-axe 28 montée coaxialement à l'axe ZZ' et traversant librement un trou 29 de la platine (18a). La vis-axe 28 a une tête de diamètre supérieur à celui du trou 29 pour présenter un épaulement (28a) à la face inférieure de la platine (18a).

Par ailleurs, il est habituel de chauffer la table d'un dispositif de soudage, afin d'avoir une différence de température minimale entre la sole de l'outil de soudage et la puce. Dans l'exemple représenté sur la figure 1, la table 11 est chauffée par une résistance électrique 30 placée en "sandwich" dans le plan de la table entre deux plaques métalliques.

Le dispositif d'application de force 25 se compose de quatre tiges verticales 31 reliant la table 11 à quatre culbuteurs respectifs 32 actionnés chacun par le doigt 33 d'un organe de commande 34. Les quatre tiges 31 traversent la platine (18a) dans des trous 35. Les axes (bb') des tiges 31 sont parallèles à l'axe ZZ' et équidistants de cet axe ainsi qu'entre eux. Les axes (bb') coupent le plan supérieur de la puce 12 en quatre points D situés dans les coins de la puce. Plus précisément, comme représenté sur la figure 2, les quatre points D sont situés de préférence au milieu des segments EF joignant les premiers quarts des côtés de la ligne rectangulaire 14 des plots 13 à partir de chaque coin. Les sommets des extrémités coniques des quatre tiges 31 sont en contact avec les sommets de cavités 36, 37 à fond conique ménagées respectivement dans la face inférieure de la table 11 et dans la paroi horizontale des culbuteurs 32. Ces culbuteurs sont mobiles en rotation dans un plan vertical autour d'axes respectifs 38 du bâti 18. Les quatre organes de commande 34 sont pilotés par un dispositif de commande 39 déterminant le mouvement de chaque tige 31. Chaque organe 34 peut être un module pneumatique à membrane couplée avec le doigt 33, ou une bobine électro-magnétique dans laquelle le doigt 33 constitue le noyau plongeur.

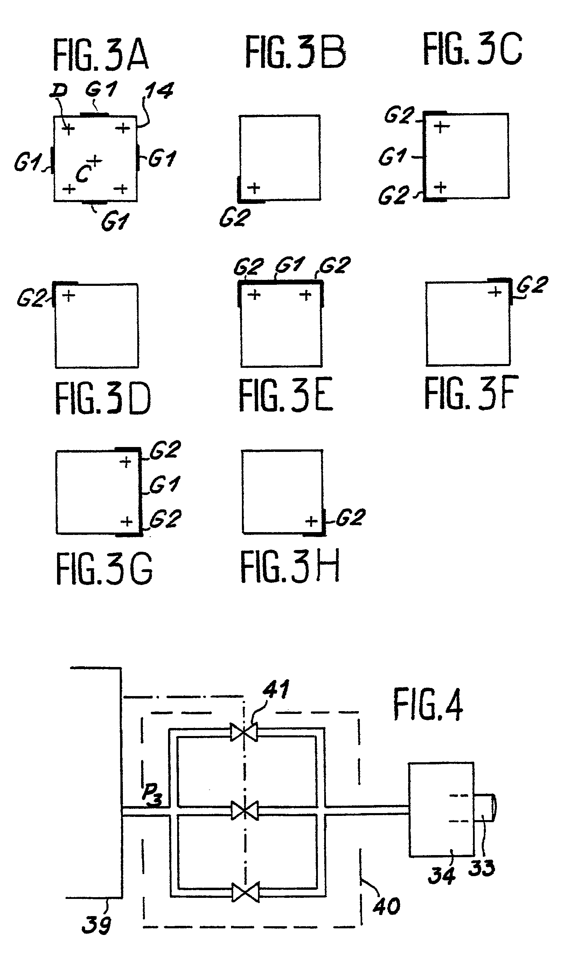

Un exemple de fonctionnement du dispositif de soudage 10 va maintenant être décrit en référence aux figures 1, 2 et 3A-3H. La figure 2 illustre la position de soudage représentée schématiquement sur la figure 3A. Cette position initiale de soudage est obtenue selon le processus suivant. En position de repos (non représentée) du dispositif de soudage 10, les doigts 33 des organes de commande 34 sont dans une position rétractée qui place la table 11 en position basse, tandis que l'outil de soudage 19 est en position haute. En position de travail, les doigts 33 amènent la table 11 dans la position haute déterminée par la butée de l'épaulement (28a) de la vis-axe 28 contre la paroi inférieure de la platine (18a) du bâti 18. L'outil de soudage 19 est abaissé pour venir s'appuyer contre la butée (18b) du bâti 18. Lors de la descente de l'outil 19, la sole 20 entre d'abord en contact avec les conducteurs 23, qui viennent ensuite en contact avec les plots 13, puis fait redescendre légèrement la table 11 jusqu'à atteindre la position de soudage représentée sur les figures 1 et 3A. L'abaissement de la table 11 écarte l'épaulement (28a) de la platine 18a d'une grandeur suffisante pour permettre l'oscillation maximale de la table et de la vis-axe 28. Les trous 29 et 35 dans la platine (18a) laissent un jeu suffisant pour permettre à la vis-axe 28 et aux tiges 31 de suivre le mouvement d'oscillation de la table.

Pour mieux mettre en relief les caractéristiques et avantages de l'invention, la position de soudage représentée sur la figure 3A suppose que la sole 20 ait une couronne circulaire centrée sur l'axe ZZ' et pourvue d'une largeur couvrant l'ensemble des plots de la puce. Si cette sole était parfaitement plane, tous les plots de la puce seraient en contact avec elle lorsque les quatre tiges sont toutes en position haute comme représenté sur la figure 1. La figure 3A correspond au cas où la sole est convexe par suite de rôdages successifs. Dans ce cas, seuls des groupes G1 de plots 13 vont être en contact avec la sole. Ces groupes G1 sont nécessairement médians, puisque les plots de chaque coin sont plus éloignés du centre C et sont supposés ne plus pouvoir être en contact avec la sole à cause de sa convexité. Le nombre de plots de chaque groupe G1 dépend bien sûr du degré de convexité de la sole. Pour la commodité de l'exposé, les groupes G1 sont supposés couvrir le tiers médian de chaque côté du carré de la ligne 14 des plots. Dans les figures 3A à 3H, chaque groupe de plots concerné par le soudage est représenté par un trait épais superposé à la ligne des plots 14 tracée en trait fin. Une croix est placée à l'intérieur de la ligne des plots à l'endroit d'un point D pour indiquer que la tige 31 correspondante est mise en position haute par l'organe 34 associé.

Les groupes de coin G2 sont successivement mis en position de soudage par la commande sélective des quatre organes 34. Les plots du coin inférieur gauche, représentés sur la figure 3B, sont soudés par le maintien en pression de l'organe 34 correspondant à la tige 31 placée dans ce coin et par le relâchement des autres organes de commande. Pour passer aux plots du coin supérieur gauche, l'organe 34 correspondant à ce coin est mis sous pression, donnant la position de soudage indiquée à la figure 3C, puis il est maintenu seul en pression pour obtenir la position de soudage de la figure 3D. Le passage par la position représentée sur la figure 3C est une contrainte seulement inhérente à la commande pneumatique des organes 34 choisis à titre d'exemple. En effet, le passage direct de la position 3B à la position 3D impliquerait le relâchement brutal de l'organe inférieur gauche et la mise sous pression brutale de l'organe supérieur gauche et provoquerait des mouvements d'oscillation indésirables de la table susceptibles d'endommager la puce. Le passage par la position 3C pallie cet inconvénient. De la même manière, on passe du soudage des plots du coin supérieur gauche aux plots du coin supérieur droit par les positions 3E et 3F, et de là jusqu'aux plots du coin inférieur droit par les positions 3G et 3H. Le soudage de tous les plots étant ainsi achevé, le système retourne à sa position initiale 3A, d'où l'outil 19 pourra être levé. Dans cet exemple, on comprend que la force de soudage que reçoit la puce 12 dans les étapes 3A à 3H est considérablement moins élevée que la force totale qui devrait être impliquée dans les dispositifs de soudage classiques. D'autre part, cet exemple fait clairement ressortir, que l'oscillation de la table permet d'assurer une qualité uniforme des soudures sur l'ensemble des plots.

On comprend maintenant que le centre C' d'oscillation de la table 11 doit être le plus près possible du centre C de la puce 12 afin de réduire ou de supprimer toute déviation du centre C par rapport à l'axe ZZ'. En effet, une telle déviation aurait pour effet de décaler l'alignement des conducteurs 23 par rapport aux plots 13. Dans l'exemple représenté sur la figure 1, les trois rayons cylindriques 26 sont respectivement pourvus de trois méplats supérieurs horizontaux (26a) qui permettent aux trois axes (aa') d'être immédiatement sous-jacents à la surface supérieure de la table et de converger ainsi au point C' très proche du centre C de la puce. Les méplats (26a) sont approximativement coplanaires avec la table pour ne pas gêner le positionnement de la puce et du ruban. L'oscillation de la table 11 d'un dispositif de soudage 10 conforme à l'invention a donc l'avantage d'assurer un soudage correct de tous les plots 13 d'une plaquette 12, indépendamment de la non-planéité de la sole 20 de l'outil de soudage 19.

Le soudage successif par groupes de plots tel que représenté sur les figures 3A à 3H peut être amélioré, notamment de la façon illustrée dans la figure 4. Selon cette variante, le dispositif de commande 39 comporte un bloc 40 de variation de l'intensité de la force appliquée sur l'organe respectif 34. Un tel bloc 40 est représenté schématiquement sur la figure 4 à titre d'exemple. Le bloc 40 illustré se compose de trois électrovannes 41 alimentées en parallèle par le dispositif de commande 39, connectées ensemble sur l'organe 34 et commandées individuellement par le dispositif de commande 39. Ainsi, chaque organe de commande 34 peut recevoir, à partir de la pression P3 fournie au bloc 40 par le dispositif de commande 39, trois pressions possibles P1, P2, P3, telles que P1 = P3/3 et P2 = 2 x P3/3. Par exemple, la pression P1 sera exercée quand les quatre organes 34 sont en action comme représenté sur les figures 1 et 6A. Ainsi, si la sole 20 était uniformément plane, elle couvrirait tous les plots, mais la force totale qui serait exercée sur la puce 12 serait réduite au tiers de celle nécessaire pour le soudage de tous les plots. Le soudage pourrait se continuer comme dans le cas de la figure 3B en exerçant la pression P3 sur l'organe 34 du coin inférieur gauche de la puce 12. Le passage à la position 3D pourrait se faire graduellement, par exemple en diminuant progressivement la pression sur l'organe 34 inférieur gauche tout en augmentant progressivement la pression sur l'organe 34 supérieur gauche. Chaque étape du soudage se ferait sur un plus petit nombre de plots que dans l'exemple décrit en référence aux figures 3A à 3H, ce qui améliorerait la qualité des soudures sur tout l'ensemble des plots indépendamment du degré de convexité de la sole.

On comprend qu'avec un bloc 40 plus perfectionné, le nombre de plots de chaque groupe successivement soudé peut être réduit, jusqu'à obtenir à la limite un soudage plot par plot comme avec les dispositifs antérieurs de soudage à outil de soudage oscillant qui ont été décrits précédemment. Ce cas limite pourrait être par exemple obtenu avec des organes 34 électromécaniques à noyau plongeur alimentés respectivement par les blocs 40 formés chacun d'un potentiomètre alimenté et commandé par le dispositif de commande 39 pour faire varier de façon continue l'intensité du courant et, par conséquent, la force appliquée sur chaque tige correspondante 31. D'une manière générale, le choix des étapes successives du procédé de soudage conforme à l'invention dépendra de nombreux paramètres tels que la fragilité de la plaquette 12, la densité des plots, la qualité requise des soudures et l'état de la sole.

On comprend aussi que la force de soudage peut être appliquée en un nombre autre que quatre (tel qu'illustré) de points prédéterminés D de la plaquette. Par exemple, trois points ou plus de quatre pourraient s'avérer avantageux selon les cas.

D'autre part, bien que l'application successive de la force de soudage sur les plots de la plaquette ait été faite dans les dispositifs 10 et 10' par oscillation de la table par rapport à la surface de la sole de l'outil de soudage, il est évident que le mouvement relatif pourrait être inversé sous la forme d'une oscillation de l'outil de soudage par rapport à une table fixe.

## Revendications

1. Procédé de soudage d'éléments (23) sur les plots correspondants (13) d'une plaquette (12) au moyen d'un outil de soudage (19) dont la sole (20) couvre l'ensemble des plots et en faisant osciller la plaquette par rapport à l'outil de soudage, caractérisé en ce qu'on fait osciller la plaquette autour d'un point (C') de sa région centrale par application sélective d'une force de soudage sur un certain nombre de points fixes prédéterminés (D), situés à l'intérieur de la ligne (14) des plots (13) de la plaquette, pour le soudage successif de groupes de plots (G1, G2).

2. Procédé selon la revendication 1, caractérisé en ce que les points prédéterminés (D) sont au nombre de quatre, situés au milieu des segments (E F) joignant approximativement les premiers quarts des côtés de la ligne (14) des plots (13) à partir de chaque coin.

3. Procédé selon la revendication 2 ou 3, caractérisé en ce que la force de soudage a une intensité variable de manière à tendre vers un soudage plot par plot.

4. Dispositif de soudage (10) pour la mise en oeuvre du procédé défini par l'une des revendications 1 à 3, destiné au soudage d'éléments (23) sur les plots correspondants (13) d'une plaquette (12) et comprenant : un outil de soudage (19) dont la sole couvre l'ensemble des plots (13) ; une table (11) destinée à supporter la plaquette (12) et montée oscillante tout en étant bloquée en rotation dans son plan ; et un dispositif d'application de force (25) de soudage faisant osciller la table par rapport à l'outil de soudage pour le soudage successif des éléments sur les plots, caractérisé en ce que la table (11) est montée oscillante autour d'un point (C') de la région du centre (C) de la plaquette et le dispositif d'application de force (25) de soudage comprend des tiges (31) actionnées par des organes de commande respectifs (34) et dont les axes (bb') sont parallèles à l'axe central (ZZ') de la table (11) et coupent le plan de la ligne (14) des plots (13) en des points fixes prédéterminés (D) équidistants de cet axe ainsi qu'entre eux et intérieurs à cette ligne.

5. Dispositif selon la revendication 4, caractérisé en ce que les points prédéterminés (D) sont au nombre de quatre, situés au milieu des segments (E, F) joignant approximativement les premiers quarts des côtés de la ligne des plots à partir de chaque coin.

6. Dispositif selon la revendication 4 ou 5, caractérisé en ce que l'intensité de la force exercée par chaque organe de commande (34) est réglable par un bloc (39).

7. Dispositif selon l'une des revendications 4 à 6, caractérisé en ce que les organes de commande (34) sont des modules pneumatiques à membrane.

8. Dispositif selon l'une des revendications 4 à 6, caractérisé en ce que les organes de commande sont des bobines électromagnétiques à noyau plongeur (33).

9. Dispositif selon l'une des revendications 4 à 8, caractérisé en ce que la table est pourvue de rayons (26) pourvu d'axes (aa') convergeant au point (C') et placés chacun entre deux colonnes fixes (27) de manière à permettre à la table d'osciller et de se déplacer verticalement.

10. Dispositif selon l'une des revendications 4 à 9, caractérisé en ce que la table est pourvue de moyens de butée (18a) contre lesquels la table est placée en une position haute de travail, et l'outil de soudage s'appuie contre une butée fixe (18b) pour placer la table dans une position de soudage dans laquelle elle peut osciller au-delà desdits moyens de butée.

## Patentansprüche

1. Verfahren zum Anlöten von Elementen (23) auf entsprechenden Klötzchen (13) einer Platte (12) mittels eines Lötwerkzeugs (19), dessen Heizplatte (20) die Gesamtheit von Klötzchen überdeckt, wobei die Platte bezüglich des Lötwerkzeugs in eine Schwingbewegung versetzt wird, dadurch gekennzeichnet, daß der Platte eine Schwingbewegung um einen Punkt (C') ihres zentralen Bereiches aufgeprägt wird, indem eine Lötkraft selektiv auf eine bestimmte Anzahl von vorbestimmten festen Punkten (D) aufgebracht wird, die im Inneren der Linie (14) von Klötzchen (13) der Platte liegen, um Gruppen von Klötzchen (G1, G2) nacheinander zu löten.

2. Verfahren nach Anspruch 1, dadurch gekennzeichnet, daß die Anzahl der vorbestimmten Punkte (D) gleich vier ist und diese Punkte in der Mitte von Segmenten (E, F) liegen, welche annähernd die vier ersten, von jeweils einer Ecke aus gemessenen Viertel der Linie (14) von Klötzchen (13) verbinden.

3. Verfahren nach Anspruch 2 oder 3, dadurch gekennzeichnet, daß die Lötkraft eine variable Intensität aufweist, so daß die Tendenz zu einem klötzchenweisen Löten besteht.

4. Lötvorrichtung zur Durchführung des Verfahrens nach einem der Ansprüche 1 bis 3, für das Anlöten von Elementen (23) auf entsprechenden Klötzchen (13) einer Platte (12) mit: einem Lötwerkzeug (19), dessen Heizplatte die Gesamtheit von Klötzchen (13) überdeckt; einem Tisch (11) zum Haltern der Platte (12), welcher für eine Schwingbewegung aber drehfest in seiner Ebene gelagert ist; und einer Vorrichtung (25) zum Aufbringen der Lötkraft, welche den Tisch mit einer Schwingbewegung gegenüber dem Lötwerkzeug für das aufeinanderfolgende Löten der Elemente an den Klötzchen antreibt, dadurch gekennzeichnet, daß der Tisch (11) für eine Schwingbewegung um einen Punkt (D') im mittleren Bereich (C) der Platte gelagert ist und die Vorrichtung (25) zum Aufbringen der Lötkraft Stangen (31) umfaßt, welche durch entsprechende Steuerorgane (34) betätigt werden und deren Achsen (bb') parallel zur zentralen Achse (ZZ') des Tisches (11) sind und die Ebene der Linie (14) von Klötzchen (13) in festen, vorbestimmten Punkten (D) schneiden, die gleiche Abstände von dieser Achse und untereinander aufweisen und im Inneren dieser Linie liegen.

5. Vorrichtung nach Anspruch 4, dadurch gekennzeichnet, daß vier vorbestimmte Punkte (D) vorhanden sind und in der Mitte der Segmente (E, F) liegen, welche annähernd die von jeweils einer Ecke aus gemessenen ersten Viertel der Seiten der Linie von Klötzchen verbinden.

6. Vorrichtung nach Anspruch 4 oder 5, dadurch gekennzeichnet, daß die Intensität der durch jedes Steuerorgan (34) ausgeübten Kraft durch einen Block (39) einstellbar ist.

7. Vorrichtung nach einem der Ansprüche 4 bis 6, dadurch gekennzeichnet, daß die Steuerorgane (34) pneumatische Membran-Moduln sind.

8. Vorrichtung nach einem der Ansprüche 4 bis 6, dadurch gekennzeichnet, daß die Steuerorgane elektromagnetische Spulen mit Tauchkern (33) sind.

9. Vorrichtung nach einem der Ansprüche 4 bis 8, dadurch gekennzeichnet, daß der Tisch mit Speichen (26) versehen ist, deren Achsen (aa') im Punkte (C') konvergieren und die jeweils zwischen zwei festen Säulen (27) in Stellung gebracht sind, so daß sie dem Tisch eine Schwingbewegung und eine Vertikalbewegung ermöglichen.

10. Vorrichtung nach einem der Ansprüche 4 bis 9, dadurch gekennzeichnet, daß der Tisch mit Anschlagmitteln (18a) versehen ist, gegen welche der Tisch in einer angehobenen Arbeitsstellung gebracht wird, und sich das Lötwerkzeug an einem festen Anschlag (18b) abstützt, um den Tisch in eine Lötstellung zu bringen, in welcher er über die Anschlagmittel hinausschwingen kann.

**Claims**

1. A method of soldering elements (23) on the corresponding pins (13) of a wafer (12) by means of a soldering tool (19), the soleplate (20) of which covers all the pins and causing the wafer to oscillate relative to the soldering tool, characterized in that the wafer is caused to oscillate about a point (C') of its central region by selective application of a soldering force on a certain number of predetermined fixed points (D), located on the interior of the line (14) of pins (13) of the wafer, for the successive soldering of groups of pins (G1, G2).

2. A method according to claim 1 characterized in that the predetermined points (D) are four in number, located in the middle of segments (E, F) approximately joining the first quarters of the sides of the line (14) of pins (13), beginning at each corner.

3. A method according to claim 2 or 3, characterized in that the soldering force has a variable intensity, so as to tend towards a soldering pin by pin.

4. A soldering apparatus (10) to implement the method defined by one of claims 1 to 3, intended for the soldering of elements (23) on the corresponding pins (13) of a wafer (12) and comprising: a soldering tool (19), the soleplate of which covers all the pins (13); a bench (11) intended to support the wafer (12) and mounted for oscillation whilst being prevented from rotating in its plane; and a device for applying a soldering force (25) causing the bench to oscillate relative to the soldering tool for successive soldering of the elements on the pins, characterized in that the bench (11) is mounted for oscillation about a point (C') of the centre region (C) of the wafer, and the device for applying a soldering force (25) comprises rods (31) actuated by respective control devices (34), and the axes (bb') of which are parallel to the central axis (ZZ') of the bench (11) and intersect the plane of the line (14) of pins (13) at predetermined fixed points (D) equidistant from this axis and from each other and disposed inside this line.

5. An apparatus according to claim 4, characterized in that the predetermined points (D) are four in number, located in the middle of segments (E, F) approximately joining the first quarters of the sides of the line of pins, beginning at each corner.

6. An apparatus according to claims 4 or 5, characterized in that the intensity of the force exerted by each control device (34) is able to be regulated by a block (39).

7. An apparatus according to one of claims 4 to 6, characterized in that the control devices (34) are pneumatic diaphragm modules.

8. An apparatus according to one of claims 4 to 6, characterized in that the control devices are electromagnetic coils with a solenoid plunger (33).

9. An apparatus according to one of claims 4 to 8, characterized in that the bench is provided with spokes (26) having axes (aa') converging at the point (C') and each placed between two fixed columns (27) so as to permit the bench to oscillate and to be displaced vertically.

10. An apparatus according to one of claims 4 to 9, characterized in that the bench is provided with stop means (18a) against which the bench is placed in a high working position, and the soldering tool rests against a fixed stop, (18b) for placing the bench in a soldering position in which it can oscillate beyond said stop means.

## FIG.1

FIG.2

FIG.3A

FIG.3B

FIG.3C

FIG.3D

FIG.3E

FIG.3F

FIG.3G

FIG.3H

FIG.4